# EUROPÄISCHE PATENTSCHRIFT

(11) **EP 3 405 838 B1**
(45) Veröffentlichungstag und Bekanntmachung des Hinweises auf die Patenterteilung: **08.01.2020**
(21) Anmeldenummer: 17700532.9
(22) Anmeldetag: 16.01.2017
(51) Int. Cl.: G03F 7/20, G03F 1/24, G21K 1/06, G02B 5/08

(54) **REFLEKTIVES OPTISCHES ELEMENT UND OPTISCHES SYSTEM FÜR DIE EUV-LITHOGRAPHIE**
REFLECTIVE OPTICAL ELEMENT AND OPTICAL SYSTEM FOR EUV LITHOGRAPHY
ÉLÉMENT OPTIQUE RÉFLÉCHISSANT ET SYSTÈME OPTIQUE POUR LA LITHOGRAPHIE À ULTRAVIOLET EXTRÊME

(30) Priorität: 21.01.2016 DE 102016200814
(43) Veröffentlichungstag der Anmeldung: 28.11.2018
(73) Patentinhaber: Carl Zeiss SMT GmbH, 73447 Oberkochen (DE)
(72) Erfinder: NOTTBOHM, Christoph, 89075 Ulm (DE)
(74) Vertreter: Werner & ten Brink
(86) Internationale Anmeldenummer: PCT/EP2017/050835
(87) Internationale Veröffentlichungsnummer: WO 2017/125362

(56) Entgegenhaltungen:
- EP-A2- 1 065 532
- WO-A1-2015/001805
- US-A1- 2012 229 785
- US-A1- 2014 078 486

## Beschreibung

Die vorliegende Erfindung bezieht sich auf ein reflektives optisches Element für den extrem ultravioletten Wellenlängenbereich mit einem sich über eine Fläche erstreckenden Viellagensystem auf einem Substrat, wobei das Viellagensystem Lagen aus mindestens zwei verschiedenen Materialien mit unterschiedlichem Realteil des Brechungsindex bei einer Wellenlänge im extrem ultravioletten Wellenlängenbereich aufweist, die abwechselnd angeordnet sind, wobei eine Lage eines der mindestens zwei Materialien mit der oder den zwischen ihr und der in zunehmender Entfernung vom Substrat nächstgelegenen Lagen gleichen Materials angeordneten Lage oder Lagen einen Stapel bildet. Außerdem bezieht sich die vorliegende Erfindung auf ein optisches System für die EUV-Lithographie bzw. auf eine EUV-Lithographievorrichtung mit einem derartigen reflektiven optischen Element. Die vorliegende Anmeldung nimmt die Priorität der deutschen Patentanmeldung 10 2016 200 184.5 vom 21. Januar 2016 in Anspruch, auf die vollumfänglich Bezug genommen wird.

In EUV-Lithographievorrichtungen werden zur Lithographie von Halbleiterbauelementen reflektive optische Elemente für den extrem ultravioletten (EUV-)Wellenlängenbereich (z.B. Wellenlängen zwischen ca. 5 nm und 20 nm) wie etwa Photomasken oder Spiegel auf der Basis von Viellagensystemen eingesetzt. Da EUV-Lithographievorrichtungen in der Regel mehrere reflektive optische Elemente aufweisen, müssen diese eine möglichst hohe Reflektivität aufweisen, um eine hinreichend hohe Gesamtreflektivität sicherzustellen.

Unter anderem um eine möglichst hohe Reflektivität der einzelnen reflektiven optischen Elemente zu gewährleisten, wird angestrebt, bei hohen lokalen Einfallswinkelbandbreiten alle Strahlen des lokalen Strahlenbündels gleichmäßig gut reflektieren zu können. Dazu werden die Anzahl und die Dicken der einzelnen Stapel des Viellagensystems optimiert. Im einfachsten Fall handelt es sich um periodische Viellagensysteme, bei denen die Anzahl der Stapel bzw. Perioden so weit reduziert wird, dass die Reflektivitätskurve die gewünschte Breite bekommt. Bei diesem Viellagensystem variiert aber immer noch die Reflektivität stark mit dem Einfallswinkel und der Wellenlänge.

Aus der EP 1 065 532 A2 ist bekannt, zur Erhöhung der maximalen Reflektivität die Periodizität eines Viellagensystem unterbrochen wird, indem zusätzliche Lagen aus einem dritten oder sogar vierten Material oder auch Lagen aus erstem Material und aus zweiten Material mit abweichender Dicke zwischen einzelnen Perioden vorgesehen werden.

In einem weiteren Schritt kann man im Viellagensystem zwei oder mehr Abschnitte vorsehen, bei denen die jeweilige Stapelgesamtdicke und das Lagenverhältnis innerhalb des Stapels unterschiedlich sind. Ferner können diese beiden Abschnitte auch unterschiedliche Stapelanzahlen aufweisen. In Varianten können die Stapeldicken und/oder die Lagendickenverhältnisse innerhalb der Stapel auch kontinuierlich über die gesamte Lagenabfolge des Viellagensystems geändert werden.

Aus der US 2003/0222225 A1 ist bekannt, das Wellenlängenband, über das eine hinreichende Reflektivität der EUV-Strahlung erreicht wird, zu verbreitern, indem angepasst an die Einfallswinkelverteilung über die Fläche des Viellagensystems das Verhältnis Γ der Lage aus Material mit geringeren Realteil des Brechungsindex zur Gesamtdicke des jeweiligen Stapels über die Fläche des Viellagensystems variiert wird. Dem liegt die Beobachtung zugrunde, dass für eine bestimmte Wellenlänge mit niedrigerem Γ der Einfallswinkel maximaler Reflektivität zu Winkeln größer 0° verschoben wird, also eine maximale Reflektivität abweichend vom normalen Einfall erreicht wird. Bevorzugt wird die Stapeldicke konstant gehalten und gleichzeitig die Dicke der Lagen aus Material mit höherem Realteil des Brechungsindex und aus Material mit niedrigerem Realteil des Brechungsindex variiert. Dies kann stufenweise oder kontinuierlich geschehen. Je nach Einfallswinkelverteilung über die Fläche kann alternativ oder zusätzlich in einem Flächenbereich auch die Stapeldicke variiert werden.

In der US 2014/0078486 A1 wird vorgeschlagen, für EUV-Spiegel für streifenden Einfall eine Spiegelschicht, die in einem ersten Einfallswinkelbereich reflektiert, und darunter ein Viellagensystem vorzusehen, das in einem zweiten Einfallswinkelbereich reflektiert. Insbesondere wird vorgeschlagen, die Spiegelschicht nur auf einer Teilfläche des EUVspiegels vorzusehen, das Viellagensystem aber auf der gesamten Fläche.

Es ist nun eine Aufgabe der vorliegenden Erfindung, ein weiteres reflektives optisches Element bereitzustellen, das eine höhere Reflektivität über größere Einfallswinkelbereiche ermöglichen kann.

Diese Aufgabe wird gelöst durch ein reflektives optisches Element für den extrem ultravioletten Wellenlängenbereich mit einem sich über eine Fläche erstreckenden Viellagensystem auf einem Substrat, wobei das Viellagensystem Lagen aus mindestens zwei verschiedenen Materialien mit unterschiedlichem Realteil des Brechungsindex bei einer Wellenlänge im extrem ultravioletten Wellenlängenbereich aufweist, die abwechselnd angeordnet sind, wobei eine Lage eines der mindestens zwei Materialien mit der oder den zwischen ihr und der in zunehmender Entfernung vom Substrat nächstgelegenen Lagen gleichen Materials angeordneten Lage oder Lagen einen Stapel bildet, wobei in mindestens einem dieser Stapel das Material der Lage mit niedrigerem und/oder das Material der Lage mit höherem Realteil des Brechungsindex über mindestens eine Teilfläche anders als über die übrige Fläche des Viellagensystems ist.

Es hat sich herausgestellt, dass nicht nur durch Variation der Lagendicken oder des Lagendickenverhältnisses innerhalb eines Stapels über die Fläche eines Viellagensystems dahingehend Einfluss auf die Winkelabhängigkeit der Reflektivität genommen werden kann, dass bei einer festen Wellenlänge eine Verbreiterung des Einfallswinkelbereichs mit höherer Reflektivität gegenüber einem unveränderten Viellagensystem beobachtet werden kann, sondern auch durch laterale Materialvariationen innerhalb mindestens einer Stapellage.

Es hat sich insbesondere herausgestellt, dass auch durch die Kombination von zwei oder mehr Substanzen innerhalb einer Lage mit niedrigerem Realteil des Brechungsindex oder innerhalb einer Lage mit höherem Realteil des Brechungsindex dahingehend Einfluss auf die Winkelabhängigkeit der Reflektivität genommen werden kann, dass bei einer festen Wellenlänge eine Verbreiterung des Einfallswinkelbereichs mit höherer Reflektivität gegenüber einem unveränderten Viellagensystem beobachtet werden kann. Die Winkelabhängigkeit der Reflektivität kann bereits durch Vorsehen einer kombinierten Lage in nur einem Stapel beeinflusst werden. Es können auch mehrere derart modifizierte Lagen mit höherem und/oder niedrigerem Realteil des Brechungsindex im Viellagensystem vorgesehen sein.

Vorteilhafterweise befinden sich diese eine oder mehreren modifizierten Stapellagen eher in einem substratfernen Abschnitt des Viellagensystems, falls nicht in allen Stapeln die Lagen aus Material mit niedrigerem und/oder höherem Realteil des Brechungsindex modifiziert sind. Es ist möglich, nur eine Lage aus Material mit niedrigerem Realteil oder nur eine Lage aus Material mit höherem Realteil des Brechungsindex oder auch beide Lagen eines Stapels wie beschrieben zu modifizieren. Falls ein Stapel mehr Lagen als eine aus Material mit höherem Realteil des Brechungsindex und eine aus Material mit niedrigerem Realteil des Brechungsindex aufweist, können auch eine oder ggf. mehrere der zusätzlichen Stapellagen in mindestens einem Stapel in Hinblick auf das Material lateral modifiziert sein. Es sei darauf hingewiesen, dass in analoger Weise bei einem festen Einfallswinkel eine Verbreiterung des Wellenlängenbereichs mit höherer Reflektivität beobachtet werden kann.

Eine Verbreiterung des Einfallswinkelbereichs, in dem höhere Reflektivitäten erreicht werden, lässt sich mit einer oder mehreren modifizierten Lagen mit niedrigerem oder höherem Realteil des Brechungsindex erreichen, die sich über nur einen Teil oder auch über die gesamte Fläche des Viellagensystems erstrecken. Besonders bevorzugt ist das reflektive optische Element für unterschiedliche Einfallswinkel von extrem ultravioletter Strahlung über die Fläche des Viellagensystems ausgelegt und variiert der Anteil der mindestens zwei Substanzen in der oder den modifizierten Lagen mit niedrigerem oder höherem Realteil des Brechungsindex in Abhängigkeit vom Einfallswinkel. Durch die Korrelation der lateralen Materialvariation mit der Einfallswinkelverteilung über die Fläche des Viellagensystems können auch über größere Einfallswinkelbereiche möglichst hohe Reflektivitätswerte erreicht werden. Untersuchungen haben gezeigt, dass über unterschiedliche Anteile der mindestens zwei Substanzen in der modifizierten Lage in ähnlicher Weise wie über das Lagendickenverhältnis Γ auf die Einfallswinkelabhängigkeit der Reflektivität bei einer bestimmten Wellenlänge Einfluss genommen werden kann. Über die Variation der Anteile kann daher die Reflektivität sehr präzise für unterschiedliche Einfallswinkelverteilung über die Fläche des Viellagensystems optimiert werden.

Der Anteil der mindestens zwei Substanzen kann stufenweise variiert werden. Vorzugsweise variiert er kontinuierlich, um möglichst passgenau den in EUV-Lithographievorrichtungen vorherrschenden kontinuierlichen Verlauf der Einfallswinkelverteilungen über die ausgeleuchtete Fläche des Viellagensystems abzubilden.

Aus herstellungstechnischen Gründen ist es von besonderem Vorteil, wenn in dem mindestens einen modifizierten Stapel das Material der Lage mit niedrigerem oder höherem Realteil des Brechungsindex eine Kombination aus genau zwei Substanzen ist.

In einer ersten bevorzugten Ausführungsform ist in dem mindestens einen Stapel die Lage mit niedrigerem und/oder höherem Realteil des Brechungsindex aus Teillagen aus den zwei oder mehr Substanzen aufgebaut, wobei deren jeweilige Teillagendicken über mindestens eine Teilfläche anders als über die übrige Fläche des Viellagensystems ist. Derartige modifizierte Lagen lassen sich durch herkömmliche Beschichtungsverfahren herstellen, indem die einzelnen Teillagen sukzessive aufgebracht werden.

In einer zweiten bevorzugten Ausführungsform ist in dem mindestens einen Stapel das Material der Lagen mit niedrigerem und/oder höherem Realteil des Brechungsindex ein Mischungsverhältnis der mindestens zwei Substanzen, wobei das Mischungsverhältnis über mindestens eine Teilfläche anders ist als über die übrige Fläche des Viellagensystems. Mittels üblicher Beschichtungsverfahren lassen sich solche modifizierten Lagen durch gleichzeitiges Aufbringen der zwei oder mehr Substanzen herstellen, wobei während des Beschichtungsvorganges die Konzentration der einzelnen Ausgangswerkstoffe entsprechend dem zu erreichenden Mischungsverhältnis eingestellt werden. Unter anderem kann es sich um die Dotierung des Lagenmaterials mit niedrigerem und/oder höherem Realteil des Brechungsindex mit über die Fläche variierendem Teilchenanteil handeln.

In einer weiteren Variante kann es sich bei dem Material der modifizierten Lage auch um Substanzen handeln, die einer chemischen Grundverbindung mit unterschiedlichen stöchiometrischen Verhältnissen entsprechen.

Vorteilhafterweise ist über mindestens eine Teilfläche die Gesamtdicke und/oder das Verhältnis der Dicke der Lage mit niedrigerem Realteil des Brechungsindex zur Gesamtdicke mindestens eines Stapels, also das Lagendickenverhältnis Γ anders als über die übrige Fläche des Viellagensystems. Beide Maßnahmen können dazu dienen, ebenfalls auf die Reflektivität für bestimmte Einfallswinkel Einfluss zu nehmen.

Vorteilhafterweise variiert das Material mindestens einer Lage hinsichtlich seiner Dichte. Laterale Dichteänderungen innerhalb einer Lage können beispielsweise mittels Ionenpolieren erreicht werden. Je nach Dauer, Intensität und Ionenenergie kann lokal eine mehr oder weniger starke Materialverdichtung erreicht werden. Je nachdem wie fokussiert der lonenstrahl ist, können die Materialverdichtungen sehr zielgerichtet und mit hoher lateraler Auflösung eingebracht werden. Dies ist insbesondere bei der Herstellung von reflektiven optischen Elementen für den Einsatz bei komplexeren Einfallswinkelverteilungen von Vorteil. Es sei darauf hingewiesen, dass analog bei festem Einfallswinkel die Wellenlängenbandbreite des reflektiven optischen Elements vergrößert werden kann. Dies gilt entsprechend für Wellenlängenverteilungen der einfallenden Strahlung.

In bevorzugten Ausführungsformen weist das reflektive optische Element als Material mit höherem Realteil des Brechungsindex Silizium, als Material mit niedrigerem Realteil des Brechungsindex Molybdän und als mindestens zwei Substanzen zwei oder mehr der Gruppe Molybdän, Ruthenium, Niob, Scandium, Titan, Kohlenstoff, Karbid auf oder weist es als Material mit niedrigerem Realteil des Brechungsindex Ruthenium, als Material mit höherem Realteil des Brechungsindex Silizium und als mindestens zwei Substanzen zwei oder mehr der Gruppe Silizium, Borkarbid, Beryllium, Bor, Kohlenstoff auf. Derartige reflektive optische Elemente eignen sich insbesondere für Wellenlängen im Bereich zwischen 12,5 nm und 15,0 nm. Durch diese spezielle Wahl der Materialien kann über einen hohen Kontrast zwischen Lagen mit niedrigerem und höherem Realteil des Brechungsindex eine hohe Reflektivität erreicht werden. Denn der Unterschied zwischen den Imaginärteilen von beispielsweise Molybdän und Ruthenium im besagten Wellenlängenbereich einerseits und Silizium andererseits ist hoch genug. Gleichzeitig unterscheiden sich Realteil und Imaginärteil des Brechungsindex von Molybdän und Ruthenium hinreichend, um deutlich Einfluss auf die Einfallswinkelverteilung der Reflektivitäten nehmen zu können. Dies gilt ebenfalls, wenn zusätzlich laterale Dichtevariationen vorgesehen sind.

Vorteilhafterweise ist über mindestens eine Teilfläche die Gesamtdicke und/oder das Verhältnis der Dicke der Lage mit niedrigerem Realteil des Brechungsindex zur Gesamtdicke mindestens eines Stapels, also das Lagendickenverhältnis Γ, anders als über die übrige Fläche des Viellagensystems. Beide Maßnahmen können dazu dienen, ebenfalls auf die Reflektivität für bestimmte Einfallswinkel Einfluss zu nehmen. Die Teilflächen mit unterschiedlichem Lagendickenverhältnis und mit Materialvariation können, müssen aber nicht deckungsgleich sein. Dies gilt analog für bestimmte Wellenlängenbereiche der einfallenden Strahlung bei festem Einfallswinkel.

Ferner wird die Aufgabe gelöst durch ein optisches System für die EUV-Lithographie bzw. durch eine EUV-Lithographievorrichtung mit mindestens einem reflektiven optischen Element wie zuvor beschrieben.

Die vorliegende Erfindung soll unter Bezugnahme auf bevorzugte Ausführungsbeispiele näher erläutert werden. Dazu zeigen
- Figur 1: schematisch eine Ausführungsform einer EUV-Lithographievorrichtung mit einem Beleuchtungssystem mit Kollektorspiegel mit Schutzlagensystem;
- Figur 2: eine schematisch Darstellung eines reflektiven optischen Elements;
- Figur 3: eine schematische Darstellung einer ersten Variante eines modifizierten Stapel;
- Figur 4a: eine schematische Darstellung einer zweiten Variante eines modifizierten Stapel;
- Figur 4b: eine schematische Draufsicht auf den Stapel aus Figur 4a;
- Figur 5: die Reflektivität einer ersten und zweiten Ausführungsform eines reflektiven optischen Elements in Abhängigkeit vom Einfallswinkel;
- Figur 6: das Mischungsverhältnis zweier Substanzen der modifizierten Lagen der ersten und zweiten Ausführungsform in Abhängigkeit vom Einfallswinkel;
- Figur 7: der Lagendickenfaktor in Abhängigkeit vom Einfallswinkel bei der ersten und zweiten Ausführungsform;
- Figur 8: die Reflektivität einer weiteren Ausführungsform eines reflektiven optischen Elements in Abhängigkeit vom Einfallswinkel;
- Figur 9: das Mischungsverhältnis zweier Substanzen der modifizierten Lagen der weiteren Ausführungsform in Abhängigkeit vom Einfallswinkel; und
- Figur 10: der Lagendickenfaktor in Abhängigkeit vom Einfallswinkel bei der weiteren Ausführungsform.

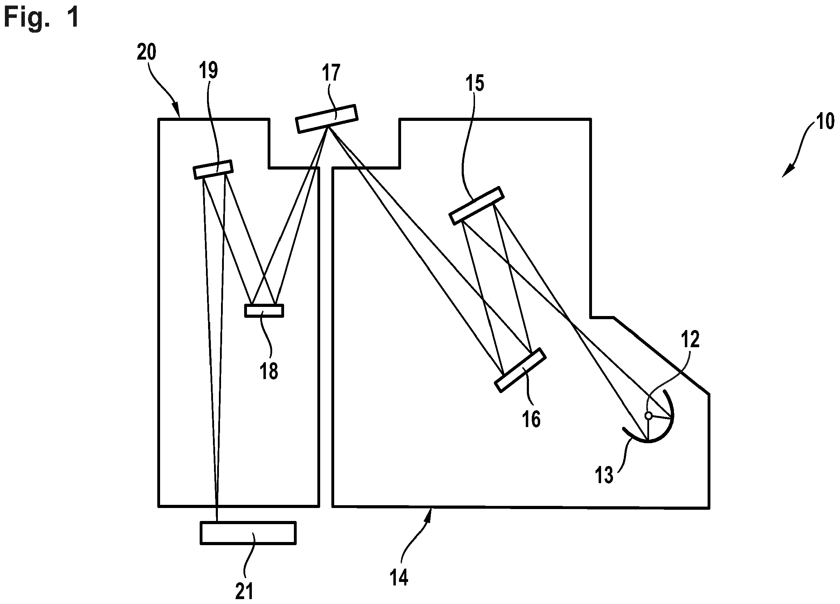

In Figur 1 ist schematisch eine EUV-Lithographievorrichtung 10 dargestellt. Wesentliche Komponenten sind das Beleuchtungssystem 14, die Photomaske 17 und das Projektionssystem 20. Die EUV-Lithographievorrichtung 10 wird unter Vakuumbedingungen betrieben, damit die EUV-Strahlung in ihrem Inneren möglichst wenig absorbiert wird.

Als Strahlungsquelle 12 kann beispielsweise eine Plasmaquelle oder auch ein Synchrotron dienen. Im hier dargestellten Beispiel handelt es sich um eine Plasmaquelle. Die emittierte Strahlung im Wellenlängenbereich von etwa 5 nm bis 20 nm wird zunächst von einem Kollektorspiegel 13 gebündelt. Der Betriebsstrahl wird dann in das Beleuchtungssystem 14 eingeführt. Im in Figur 1 dargestellten Beispiel weist das Beleuchtungssystem 14 zwei Spiegel 15, 16 auf. Die Spiegel 15, 16 leiten den Strahl auf die Photomaske 17, die die Struktur aufweist, die auf den Wafer 21 abgebildet werden soll. Bei der Photomaske 17 handelt es sich ebenfalls um ein reflektives optisches Element für den EUV-Wellenlängenbereich, das je nach Herstellungsprozess ausgewechselt wird. Mit Hilfe des Projektionssystems 20 wird der von der Photomaske 17 reflektierte Strahl auf den Wafer 21 projiziert und dadurch die Struktur der Photomaske auf ihn abgebildet. Das Projektionssystem 20 weist im dargestellten Beispiel zwei Spiegel 18, 19 auf. Es sei darauf hingewiesen, dass sowohl das Projektionssystem 20 als auch das Beleuchtungssystem 14 jeweils nur einen oder auch drei, vier, fünf und mehr Spiegel aufweisen können.

Um über möglichst große Einfallswinkel und Einfallswinkelbereiche eine möglichst hohe und konstante Reflektivität zu gewährleisten, weisen einer oder mehrere der Spiegel oder auch die Photomaske ein besonderes Viellagensystem auf, wobei das Viellagensystem Lagen aus mindestens zwei verschiedenen Materialien mit unterschiedlichem Realteil des Brechungsindex bei einer Wellenlänge im extrem ultravioletten Wellenlängenbereich aufweist, die abwechselnd angeordnet sind, wobei eine Lage eines der mindestens zwei Materialien mit der oder den zwischen ihr und der in zunehmender Entfernung vom Substrat nächstgelegenen Lagen gleichen Materials angeordneten Lage oder Lagen einen Stapel bildet, wobei in mindestens einem Stapel das Material der Lage mit niedrigerem oder höherem Realteil des Brechungsindex ein Kombination aus mindestens zwei Substanzen ist, deren jeweiliger Anteil an dieser Lage über mindestens eine Teilfläche anders als über die übrige Fläche des Viellagensystems ist.

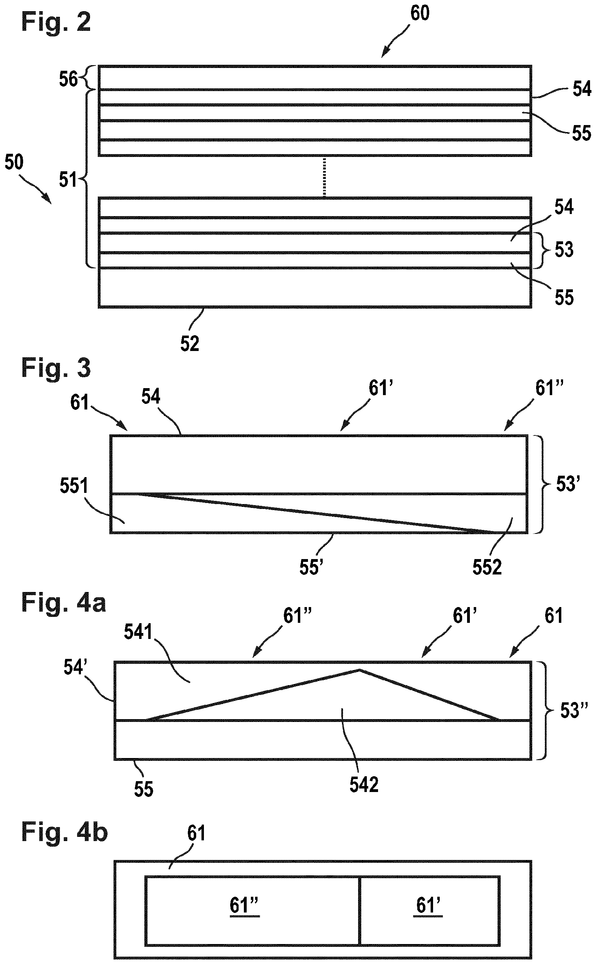

In Figur 2 ist schematisch die Struktur eines reflektiven optischen Elements 50 dargestellt. Bei dem dargestellten Beispiel handelt es sich um ein reflektives optisches Element, das auf einem Viellagensystem 51 basiert. Dabei handelt es sich im wesentlichen um alternierend aufgebrachte Lagen eines Materials mit höherem Realteil des Brechungsindex bei der Arbeitswellenlänge, bei der beispielsweise die lithographische Belichtung durchgeführt wird, (auch Spacer 54 genannt) und eines Materials mit niedrigerem Realteil des Brechungsindex bei der Arbeitswellenlänge (auch Absorber 55 genannt), wobei im hier dargestellten Beispiel ein Absorber-Spacer-Paar einen Stapel 53 bildet, der bei periodischen Viellagensystemen einer Periode entspricht. Dadurch wird in gewisser Weise ein Kristall simuliert, dessen Netzebenen den Absorberlagen entsprechen, an denen Bragg-Reflexion stattfindet. Die Dicken der einzelnen Lagen 54, 55 wie auch der sich wiederholenden Stapel 53 können über das gesamte Viellagensystem 51 konstant sein oder auch variieren, je nach dem, welches spektrale oder winkelabhängige Reflexionsprofil erreicht werden soll. Das Reflexionsprofil kann auch gezielt beeinflusst werden, indem die Grundstruktur aus Absorber 55 und Spacer 54 um weitere Absorber- oder Spacer-Materialien ergänzt wird, um die mögliche maximale Reflektivität bei der jeweiligen Arbeitswellenlänge zu erhöhen. Dazu können in manchen Stapeln Absorber und/oder Spacer-Materialien gegeneinander ausgetauscht werden oder die Stapel aus mehr als einem Absorber- und/oder Spacermaterial aufgebaut werden oder zusätzliche Lagen aus weiteren Materialien aufweisen. Die Absorber- und Spacermaterialien können über alle Stapel konstante oder auch variierende Dicken aufweisen, um die Reflektivität zu optimieren. Ferner können in einzelnen oder allen Stapeln auch zusätzliche Lagen beispielsweise als Diffusionsbarrieren zwischen Spacer- und Absorberlagen 54, 55 vorgesehen werden.

Das Viellagensystem 51 ist auf einem Substrat 52 aufgebracht und bildet eine reflektive Fläche 60. Als Substratmaterialien werden bevorzugt Materialien mit geringem Wärmeausdehnungskoeffizienten gewählt. Bei der ersten an das Substrat 52 grenzenden Lage kann es sich um eine Absorber-, eine Spacer- oder auch eine zusätzliche Lage handeln. Auf dem Viellagensystem 51 kann eine Schutzschicht 56 vorgesehen sein, die das reflektive optische Element 50 u.a. vor Kontamination schützt.

In Figur 3 ist schematisch der Aufbau einer ersten beispielhaften Variante eines modifizierten Stapels 53' aus einer Spacerlage 54 und einer kombinierten Absorberlage 55' dargestellt. Im hier dargestellten Beispiel besteht die kombinierte Absorberlage 55' aus genau zwei Teillagen 551 und 552 aus jeweils unterschiedlichen Substanzen. Der Anteil der beiden Substanzen an der kombinierten Absorberlage 55' ändert sich im in Figur 3 dargestellten Beispiel dadurch, dass ihre jeweilige Teillagendicke sich über verschiedene Teilabschnitte 61, 61', 61" des Viellagensystems in lateraler Ausdehnung ändert. So ist bei dem in Figur 3 dargestellten Beispiel auf der linken Seite 61 die Dicke der Teillage 551 maximal und auf der rechten Seite 61" die Dicke der Teillage 552 maximal. Dazwischen 61' nimmt die Dicke der Teillage 551 kontinuierlich ab bzw. die Dicke der Teillage 552 kontinuierlich zu. Dadurch wird erreicht, dass im in Figur 3 linken Bereich 61 des Viellagensystems die Reflektivität für andere Einfallswinkel maximal ist als für den in Figur 3 rechten Bereich 61" des Viellagensystems. Die tatsächlichen Einfallswinkel und Reflektivitäten hängen im Einzelfall u.a. von der Material- bzw. Substanzwahl sowie den Lagen- und Teillagendicken ab. Die Teillagendickenänderung kann sich in eine Richtung der Fläche des Viellagensystems erstrecken und in die andere Richtung senkrecht dazu in der Flächenebene konstant bleiben. Teillagendickenänderungen können aber ebenso in zwei Dimensionen über die Fläche erfolgen. Je nach dem, welche Einfallswinkelbereiche eine möglichst hohe Reflektivität aufweisen sollen, können ein oder mehr Stapel 53 in der hier beschriebenen Weise modifiziert werden. In einer Abwandlung der in Figur 3 dargestellten Ausführungsform kann die modifizierte Absorberlage 55' anstatt aus Teillagen auch aus einer Mischung von zwei Substanzen hergestellt sein. Anstelle der Teillagendicke kann entsprechend dem gewünschten Einfallswinkel mit maximaler Reflektivität das Mischungsverhältnis bzw. der Konzentrationsgradient der beiden Substanzen lokal angepasst werden. Unter anderem kann es sich dabei um eine variierende Dotierung des Lagenmaterials handeln. Der Verlauf des Mischungsverhältnisses bzw. des Konzentrationsgradients kann dem Verlauf der Teillagendickenänderung entsprechen.

In Figur 4a ist eine weitere beispielhafte Variante eines modifizierten Stapels 53" dargestellt, bei dem die Spacerlage 54' als eine Kombination aus zwei Substanzen ausgebildet ist. Sie sind als Teillagen 541, 542 aufgebracht, deren Dicke über die Teilflächen 61, 61', 61" des Viellagensystems kontinuierlich variiert - bevorzugt in Abhängigkeit der Verteilung der Einfallswinkel über die Fläche eines Spiegels oder einer Photomaske oder eines anderen reflektiven optischen Elements, das auf diesem Viellagensystem basiert -, so dass der jeweilige Anteil der einzelnen Substanz an der Spacerlage 54' kontinuierlich variiert. In Figur 4b ist der Stapel schematisch von oben dargestellt. Die gesamte Fläche, die der Fläche des reflektiven optischen Elements bzw. dessen Viellagensystem entspricht, ist im vorliegenden Beispiel in drei Teilflächen 61, 61', 61" aufgeteilt. Im Teilflächenbereich 61 ist das Material der Spacerlage 54' unverändert, während es in den Teilflächenbereichen 61', 61" unterschiedlich variiert. In weiteren Ausführungen kann es sich auch um zwei, vier, fünf, sechs oder mehr Teilflächen handeln. Auch bei Abwandlungen dieser Variante kann die modifizierte Spacerlage 54' anstatt aus Teillagen auch aus einer Mischung von zwei Substanzen hergestellt sein. Anstelle der Teillagendicke kann entsprechend dem gewünschten Einfallswinkel mit maximaler Reflektivität das Mischungsverhältnis bzw. der Konzentrationsgradient der beiden Substanzen über die Fläche des Viellagesystems angepasst werden. Unter anderem kann es sich dabei um eine variierende Dotierung des Lagenmaterials handeln.

In den zuvor beschriebenen Beispielen ist über mindestens eine Teilfläche das Verhältnis der Dicke der Lage mit niedrigerem Realteil des Brechungsindex zur Gesamtdicke mindestens eines Stapels, also das Lagendickenverhältnis Γ anders als über die übrige Fläche des Viellagensystems. In Abwandlungen kann alternativ oder zusätzlich über mindestens eine Teilfläche die Gesamtdicke anders als über die übrige Fläche des Viellagensystems sein.

In weiteren Abwandlungen kann zusätzlich auch die Lagendichte lateral über die Fläche variieren. Man kann auch die einzelnen Maßnahmen zur lateralen Materialvariation miteinander kombinieren. Diese wie auch die zuvor genannten Maßnahmen können dazu dienen, ebenfalls auf die Reflektivität für bestimmte Einfallswinkel Einfluss zu nehmen.

Bei der Wahl der Materialien für Spacer- und Absorberlagen und insbesondere der Substanzen für die kombinierte Lage ist es von Vorteil, wenn die zwei oder mehr Substanzen bei einer Wellenlänge im extrem ultravioletten Wellenlängenbereich möglichst unterschiedliche Realteile des Brechungsindex aufweisen, um durch Änderungen ihrer Anteile messbar Einfluss auf die Einfallswinkelverteilung der Reflektivität nehmen zu können. Gerade für den EUV-Wellenlängenbereich sind für die modifizierte Absorberlage beispielsweise Kombinationen aus Molybdän, Ruthenium, Niob, Scandium, Kohlenstoff und/oder Titan geeignet, wobei die jeweilige Kombination auch in Form einer Legierung oder einer Verbindung wie etwa ein Karbid, z.B. Molybdänkarbid in variablen stöchiometrischen Zusammensetzungen vorliegen kann. Für die modifizierte Spacerlage sind für den EUV-Wellenlängenbereich beispielsweise Kombinationen aus Silizium, Borkarbid, Beryllium, Bor und/oder Kohlenstoff geeignet.

In einer ersten bevorzugten Ausführungsform für reflektive optische Elemente für den EUV-Wellenlängenbereich zwischen 12,5 nm und 15,0 nm wurden zwei Spiegel untersucht, deren Viellagensystem je fünfzehn Stapel aus jeweils Silizium als Spacer und einer Kombination aus Molybdän und Ruthenium als kombinierte Absorberlagen aufwiesen. Das Verhältnis von kombinierter Absorberlagedicke zu Stapeldicke lag bei beiden Spiegeln konstant bei 0,37. Die modifizierten Absorberlagen wurden durch Cosputtern hergestellt, so dass sich eine Mischung mit lokal unterschiedlichen Konzentrationen von Molybdän bzw. Ruthenium erhalten ließ.

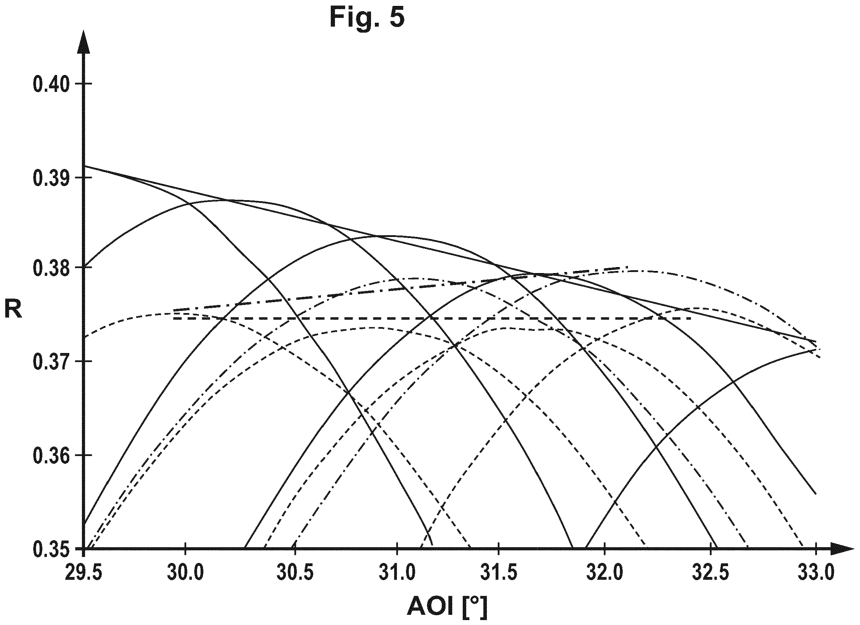

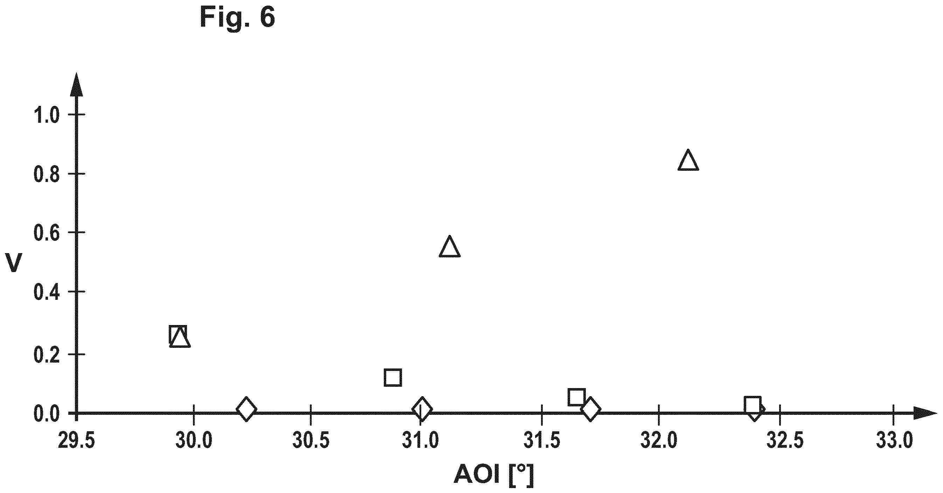

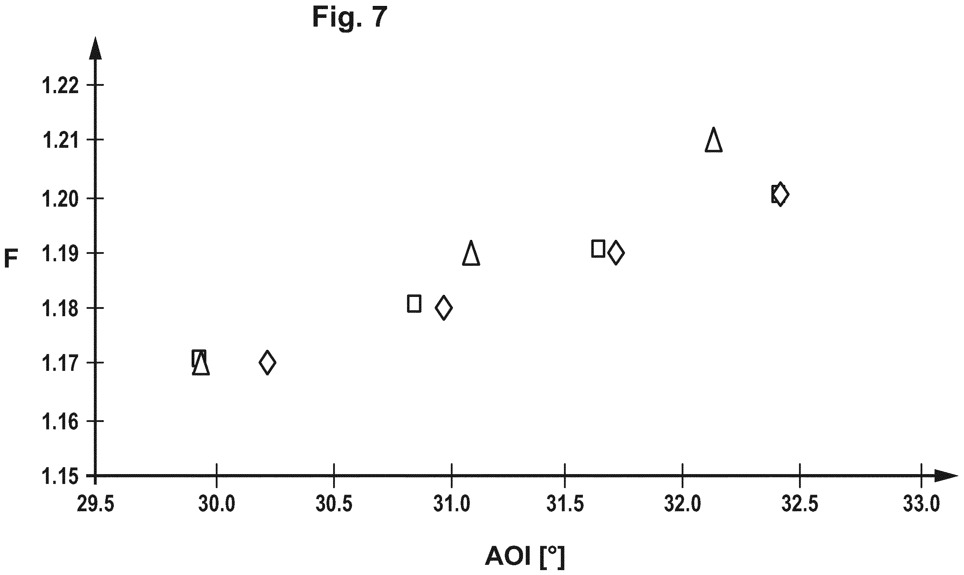

In Figur 5 ist mit gestrichelter Linie die Reflektivität R in Abhängigkeit vom Einfallswinkel für verschiedene Verhältnisse (siehe auch Figur 6) von Ruthenium zu Molybdän für den ersten Spiegel und mit strich-punktierter Linie für den zweiten Spiegel aufgetragen. Die Wellenlänge des einfallenden Strahls lag bei 13,5 nm. Als Vergleich sind mit durchgezogener Linie die Reflektivitätskurven für einen ersten Vergleichsspiegel mit herkömmlichem Viellagensystem dargestellt, d.h. mit Viellagensystem aus 15 Stapeln mit Silizium-Spacerlagen und Molybdän-Absorberlagen. In Figur 6 sind die Verhältnisse V von Ruthenium zu Molybdän in den fünfzehn Absorberlagen für den ersten Spiegel mit Rechtecken, für den zweiten Spiegel mit Dreiecken und für den Vergleichsspiegel mit Rauten gegenüber dem Einfallswinkel aufgetragen. Dabei ist das Verhältnis V derart definiert, dass V=1 einem gleichgroßen Anteil von Molybdän und Ruthenium und V=0 einer reinen Molybdänlage entspricht. Der Einfallswinkel wurde immer in Grad und relativ zur Oberflächennormalen angegeben. Um die Reflektivität für jeden Einfallswinkel weiter zu optimieren, wurde die Dicke der Stapel im Vergleich zum normalen Einfall um einen Faktor F erhöht. Dieser Faktor F ist in Figur 7 ebenfalls für den ersten Spiegel mit Rechtecken, für den zweiten Spiegel mit Dreiecken und für den Vergleichsspiegel mit Rauten gegenüber dem Einfallswinkel aufgetragen.

Beim ersten Vergleichsspiegel fällt die Reflektivität im Maximum mit zunehmendem Einfallswinkel trotz variablem Stapeldickenfaktor F ab. Durch die Variation des Verhältnisses V von Ruthenium zu Molybdän zwischen ca. 0,25 für Einfallswinkel von knapp 30° auf 0 für Einfallswinkel von knapp 32,5° beim ersten Spiegel kann die Reflektivität über ein Winkelintervall von etwa 2,5° im Wesentlichen konstant gehalten werden. Dabei weicht der Stapeldickenfaktor F nur zu kleineren Einfallswinkeln hin leicht von dem des ersten Vergleichsspiegels ab. Durch Variation des Verhältnisses V zwischen ca. 0,25 für einen Einfallswinkel von knapp 30° auf knapp 0,85 für einen Einfallswinkel von etwas über 32° beim zweiten Spiegel kann sogar ein Ansteigen der maximalen Reflektivität erreicht werden. Aufgrund des hohen Rutheniumanteils wird dabei mit etwas höheren Stapeldicken gearbeitet als beim ersten Spiegel und beim ersten Vergleichsspiegel. Mit dem zweiten Spiegel können in optischen Systemen bzw. EUV-Lithographievorrichtungen Reflektivitätsgradienten, die von anderen reflektiven optischen Elementen verursacht werden, kompensiert werden.

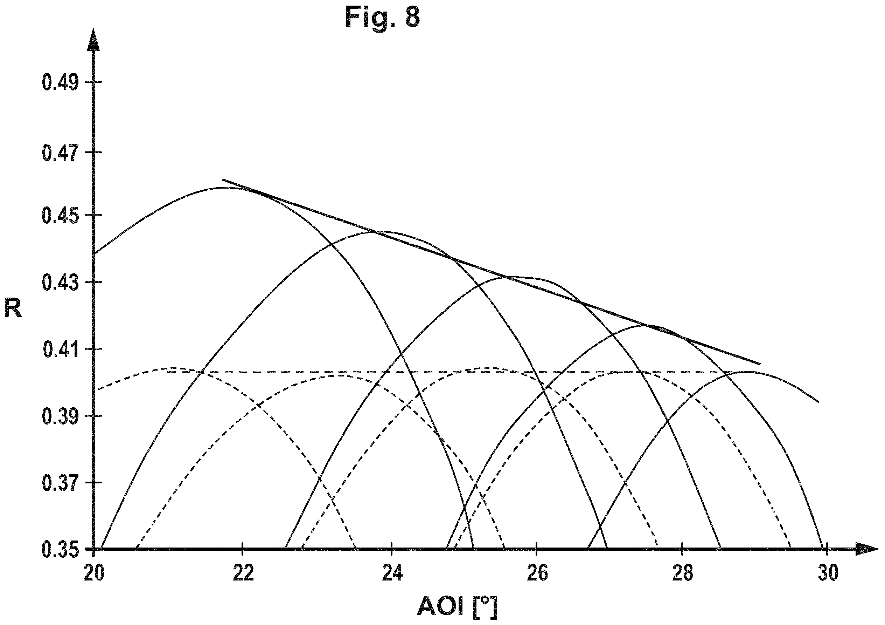

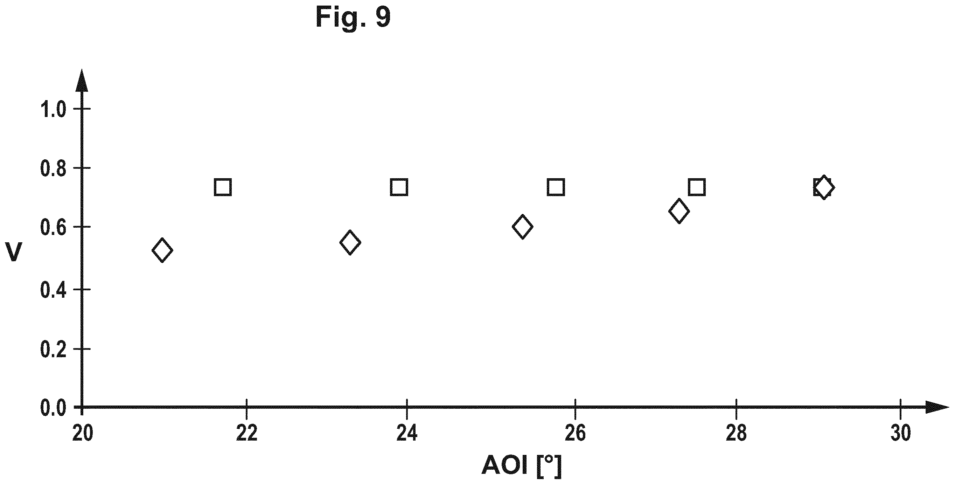

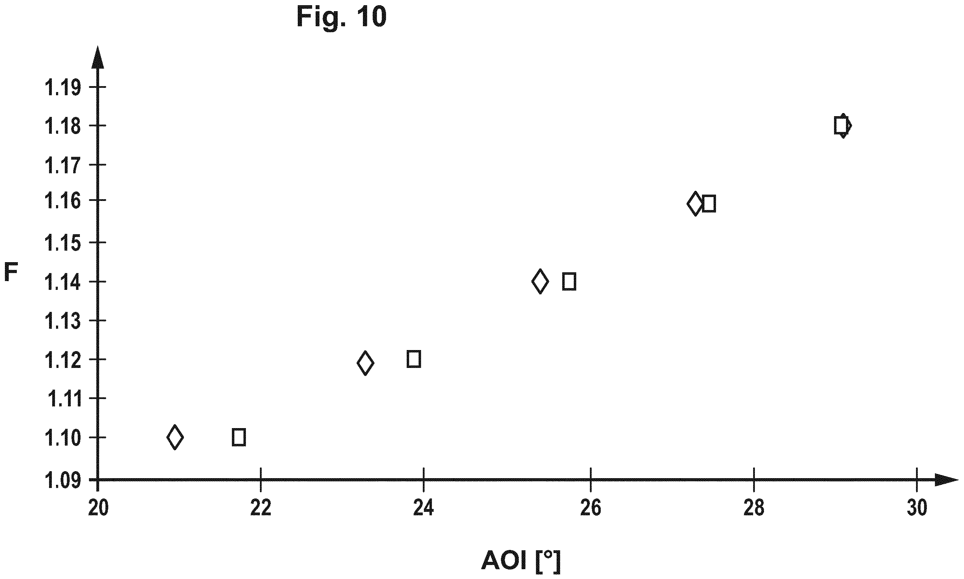

Es wurde ein weiterer Spiegel entsprechend einer weiteren bevorzugten Ausführungsform untersucht. Er wies ein Viellagensystem aus fünfzehn Stapeln mit Absorberlagen aus Ruthenium und kombinierten Spacerlagen auf, bei denen es sich um eine Kombination aus Silizium und Borkarbid mit über die Spiegelfläche variablem Anteil handelte. Das Verhältnis von Absorberlagendicke zu Stapeldicke lag konstant bei 0,37. In Figur 8 ist mit gestrichelter Linie die Reflektivität R in Abhängigkeit vom Einfallswinkel für verschiedene Verhältnisse von Borkarbid zu Silizium für den weiteren Spiegel aufgetragen. Die Wellenlänge des einfallenden Strahls lag erneut bei 13,5 nm. Als Vergleich sind mit durchgezogener Linie die Reflektivitätskurven für einen zweiten Vergleichsspiegel mit Viellagensystem aus Silizium-Spacerlagen mit konstant dicken Borkarbidzwischenlagen als Diffusionsbarrieren und Ruthenium-Absorberlagen dargestellt. In Figur 9 sind die Verhältnisse V (siehe auch Figur 9) von Silizium zu Borkarbid in den fünfzehn Spacerlagen für diesen weiteren Spiegel mit Rauten und für den zweiten Vergleichsspiegel mit Rechtecken gegenüber dem Einfallswinkel aufgetragen. Dabei ist das Verhältnis V derart definiert, dass V=1 einer reinen Siliziumlage und V=0 einer reinen Borkarbidlage entspricht. Für den zweiten Vergleichsspiegel wurden die Spacerlagen mit den Diffusionsbarrieren aus Borkarbid als Einheit betrachtet, so dass sich ein konstantes Verhältnis von ca. 0,75 von Silizium zu Borkarbid ergab. Der Einfallswinkel wurde erneut immer in Grad und relativ zur Oberflächennormalen angegeben. Um die Reflektivität für jeden Einfallswinkel zu optimieren, wurde die Dicke der Stapel im Vergleich zum normalen Einfall um einen Faktor F erhöht. Dieser Faktor F ist in Figur 10 ebenfalls für den weiteren Spiegel mit Rauten und für den zweiten Vergleichsspiegel mit Rechtecken gegenüber dem Einfallswinkel aufgetragen.

Beim zweiten Vergleichsspiegel fällt erneut die Reflektivität im Maximum mit zunehmendem Einfallswinkel trotz variablem Stapeldickenfaktor F ab. Durch die Variation des Verhältnisses V von Silizium zur Borkarbid zwischen ca. 0,55 für Einfallswinkel von knapp 21° auf ca. 0,75 für Einfallswinkel von etwa 29° beim weiteren Spiegel kann die Reflektivität über ein Winkelintervall von etwa 8° im Wesentlichen konstant gehalten werden. Dabei weicht der Stapeldickenfaktor F nur zu kleineren Einfallswinkeln hin leicht von dem des zweiten Vergleichsspiegels ab. Besonders einfach lässt sich das Viellagensystem des weiteren Spiegels herstellen, indem man das Herstellungsverfahren des zweiten Vergleichsspiegels dahingehend abändert, dass die Dicke der Borkarbidlagen lokal über die Fläche in Abhängigkeit vom erwarteten Einfallswinkel beim Einsatz als optisches reflektives Element variiert wird.

Es sei darauf hingewiesen, dass zu kleineren Einfallswinkeln hin über größere Winkelintervalle die maximale Reflektivität konstant bleibt. Es wird ferner darauf hingewiesen, dass die Winkelabhängigkeit der maximalen Reflektivität zusätzlich über die Variation des Verhältnisses der Absorberlagendicke zu Stapeldicke über die Fläche des Viellagensystems beeinflusst werden kann.

Aufgrund der stark reduzierten Einfallswinkelabhängigkeit der maximalen Reflektivität lassen sich die hier vorgestellten reflektiven optischen Elemente besonders gut in optischen Systemen für die EUV-Lithographie bzw. in EUV-Lithographievorrichtungen einsetzen, bei denen allgemein insbesondere wegen des Vorhandenseins von mehreren reflektiven optischen Elementen und dem Bemühen diese möglichst platzsparend anzuordnen mit großen Einfallswinkelschwankungen über die Fläche eines ausgeleuchteten reflektiven optischen Elementes zu rechnen ist.

### Bezugszeichen

- 10: EUV-Lithographievorrichtung
- 12: EUV-Strahlungsquelle
- 13: Kollektorspiegel
- 14: Beleuchtungssystem
- 15: erster Spiegel
- 16: zweiter Spiegel
- 17: Maske
- 18: dritter Spiegel
- 19: vierter Spiegel
- 20: Projektionssystem
- 21: Wafer
- 50: reflektives optisches Element
- 51: Viellagensystem
- 52: Substrat
- 53, 53', 53": Stapel
- 54, 54': Spacer
- 55, 55': Absorber
- 56: Schutzlage
- 551, 552: Absorberteillage
- 541, 542: Spacerteillage
- 60: reflektive Fläche
- 61, 61', 61": Teilflächen

## Patentansprüche

1. Reflektives optisches Element für den extrem ultravioletten Wellenlängenbereich mit einem sich über eine Fläche erstreckenden Viellagensystem auf einem Substrat, wobei das Viellagensystem Lagen aus mindestens zwei verschiedenen Materialien mit unterschiedlichem Realteil des Brechungsindex bei einer Wellenlänge im extrem ultravioletten Wellenlängenbereich aufweist, die abwechselnd angeordnet sind, wobei eine Lage eines der mindestens zwei Materialien mit der oder den zwischen ihr und der in zunehmender Entfernung vom Substrat nächstgelegenen Lagen gleichen Materials angeordneten Lage oder Lagen einen Stapel bildet, **dadurch gekennzeichnet, dass** in mindestens einem dieser Stapel (53', 53") das Material der Lage (55') mit niedrigerem und/oder das Material der Lage (54') mit höherem Realteil des Brechungsindex eine Kombination aus mindestens zwei Substanzen ist, deren jeweiliger Anteil an dieser Lage (55', 54') über mindestens eine Teilfläche (61', 61") anders als über die übrige Fläche (61) des Viellagensystems (51) ist.

2. Reflektives optisches Element nach Anspruch 1, das für unterschiedliche Einfallswinkel von EUV-Strahlung über die Fläche des Viellagensystems ausgelegt ist, **dadurch gekennzeichnet, dass** der Anteil der mindestens zwei Substanzen in Abhängigkeit vom Einfallswinkel variiert.

3. Reflektives optisches Element nach Anspruch 1 oder 2, **dadurch gekennzeichnet, dass** der Anteil der mindestens zwei Substanzen kontinuierlich variiert.

4. Reflektives optisches Element nach einem der Ansprüche 1 bis 3, **dadurch gekennzeichnet, dass** in dem mindestens einen Stapel (53') das Material der Lage (55', 54') mit niedrigerem oder höherem Realteil des Brechungsindex eine Kombination aus genau zwei Substanzen ist.

5. Reflektives optisches Element nach einem der Ansprüche 1 bis 4, **dadurch gekennzeichnet, dass** in dem mindestens einen Stapel (53', 53") die Lage (55', 54') mit niedrigerem oder höherem Realteil des Brechungsindex aus Teillagen (551, 552, 541, 542) aus den zwei oder mehr Substanzen aufgebaut ist, deren jeweilige Teillagendicken über mindestens eine Teilfläche (61', 61", 61) anders als über die übrige Fläche (61, 61', 61") des Viellagensystems (51) sind.

6. Reflektives optisches Element nach einem der Ansprüche 1 bis 4, **dadurch gekennzeichnet, dass** in dem mindestens einen Stapel (53', 53") das Material der Lage (55') mit niedrigerem oder höherem Realteil des Brechungsindex ein Mischungsverhältnis der mindestens zwei Substanzen aufweist, das über mindestens eine Teilfläche (61', 61", 61) anders als über die übrige Fläche (61, 61', 61") des Viellagensystems (51) ist.

7. Reflektives optisches Element nach einem der Ansprüche 1 bis 6, **dadurch gekennzeichnet, dass** über mindestens eine Teilfläche die Gesamtdicke und/oder das Verhältnis der Dicke der Lage (55, 55') mit niedrigerem Realteil des Brechungsindex zur Gesamtdicke mindestens eines Stapels (53) anders als über die übrige Fläche des Viellagensystems (51) ist.

8. Reflektives optisches Element nach Anspruch 1 oder 2, **dadurch gekennzeichnet, dass** das Material mindestens einer Lage (54, 54', 55, 55') hinsichtlich seiner Dichte variiert.

9. Reflektives optisches Element nach einem der Ansprüche 1 bis 8, **dadurch gekennzeichnet, dass** es als Material mit höherem Realteil des Brechungsindex Silizium, als Material mit niedrigerem Realteil des Brechungsindex Molybdän und als mindestens zwei Substanzen zwei oder mehr der Gruppe Molybdän, Ruthenium, Niob, Scandium, Titan, Kohlenstoff, Karbid aufweist oder es als Material mit niedrigerem Realteil des Brechungsindex Ruthenium, als Material mit höherem Realteil des Brechungsindex Silizium und als mindestens zwei Substanzen zwei oder mehr der Gruppe Silizium, Borkarbid, Beryllium, Bor, Kohlenstoff aufweist.

10. Optisches System für die EUV-Lithographie mit einem reflektiven optischen Element gemäß einem der Ansprüche 1 bis 9.

11. Optisches System nach Anspruch 10, bei dem auf das reflektive optische Element extrem ultraviolette Strahlung einer Wellenlänge mit über die Fläche des Viellagensystems variierendem Einfallswinkel auftrifft, **dadurch gekennzeichnet, dass** der Anteil der mindestens zwei Substanzen in Abhängigkeit vom Einfallswinkel variiert.

12. EUV-Lithographievorrichtung mit einem reflektiven optischen Element gemäß einem der Ansprüche 1 bis 9 oder einem optischen System gemäß Anspruch 10 oder 11.

## Claims

1. Reflective optical element for the extreme ultraviolet wavelength range having a multilayer system, extending over a surface, on a substrate, wherein the multilayer system has layers from at least two different materials with a different real part of the refractive index at a wavelength in the extreme ultraviolet wavelength range, which are arranged in alternation, wherein one layer of one of the at least two materials forms a stack with the layer or layers that is/are arranged between the former and the layer of the same material that is located closest at an increasing distance from the substrate, **characterized in that** in at least one of these stacks (53', 53") the material of the layer (55') with the lower real part of the refractive index and/or the material of the layer (54') with the higher real part of the refractive index is a combination of at least two substances, whose respective proportion of said layer (55', 54') over at least one partial surface (61', 61") is different than over the remaining surface (61) of the multilayer system (51).

2. Reflective optical element according to Claim 1, designed for different angles of incidence of EUV radiation over the surface of the multilayer system, **characterized in that** the proportion of the at least two substances varies in dependence on the angle of incidence.

3. Reflective optical element according to Claim 1 or 2, **characterized in that** the proportion of the at least two substances varies continuously.

4. Reflective optical element according to one of Claims 1 to 3, **characterized in that** in the at least one stack (53') the material of the layer (55', 54') with the lower or higher real part of the refractive index is a combination of exactly two substances.

5. Reflective optical element according to one of Claims 1 to 4, **characterized in that** in the at least one stack (53', 53") the layer (55', 54') having the lower or higher real part of the refractive index is made up of partial layers (551, 552, 541, 542) of the two or more substances whose respective partial layer thicknesses over at least one partial surface (61', 61", 61) are different than over the remaining surface (61, 61', 61") of the multilayer system (51).

6. Reflective optical element according to one of Claims 1 to 4, **characterized in that** in the at least one stack (53', 53") the material of the layer (55') with the lower or higher real part of the refractive index has a mixture ratio of the at least two substances that is different over at least one partial surface (61', 61", 61) than over the remaining surface (61, 61', 61") of the multilayer system (51).

7. Reflective optical element according to one of Claims 1 to 6, **characterized in that** the total thickness and/or the ratio of the thickness of the layer (55, 55') with the lower real part of the refractive index to the total thickness of at least one stack (53) over at least one partial surface is different than over the remaining surface of the multilayer system (51).

8. Reflective optical element according to Claim 1 or 2, **characterized in that** the material of at least one layer (54, 54', 55, 55') varies in terms of its density.

9. Reflective optical element according to one of Claims 1 to 8, **characterized in that** it includes silicon as the material with the higher real part of the refractive index, molybdenum as the material with the lower real part of the refractive index, and two or more of the group molybdenum, ruthenium, niobium, scandium, titanium, carbon, carbide as at least two substances, or includes ruthenium as the material having the lower real part of the refractive index, silicon as the material having the higher real part of the refractive index, and two or more of the group silicon, boron carbide, beryllium, boron, carbon as at least two substances.

10. EUV lithographic optical system having a reflective optical element according to one of Claims 1 to 9.

11. Optical system according to Claim 10, in which extreme ultraviolet radiation of a wavelength is incident on the reflective optical element with an angle of incidence that varies over the surface of the multilayer system, **characterized in that** the proportion of the at least two substances varies in dependence on the angle of incidence.

12. EUV lithography apparatus having a reflective optical element according to one of Claims 1 to 9 or an optical system according to Claim 10 or 11.

## Revendications

1. Élément optique réfléchissant destiné à la gamme de longueurs d'onde ultraviolette extrême comprenant un système multicouche s'étendant sur une surface et placé sur un substrat, le système multicouche comprenant des couches formées d'au moins deux matériaux différents ayant des parties réelles d'indice de réfraction différentes à une longueur d'onde située dans la gamme de longueurs d'onde ultraviolette extrême, lesquelles couches sont disposées en alternance, une couche de l'un des au moins deux matériaux formant un empilement avec au moins une couche disposée entre celle-ci et la couche de même matériau la plus proche du substrat à distance croissante, **caractérisé en ce que**, dans l'un au moins de ces empilements (53', 53"), le matériau de la couche (55') ayant la partie réelle d'indice de réfraction la plus faible et/ou le matériau de la couche (54') ayant la partie réelle d'indice de réfraction la plus élevée sont une combinaison d'au moins deux substances dont la proportion respective au niveau de cette couche (55', 54') sur au moins une partie de surface (61', 61") est différente de celle sur la surface restante (61) du système multicouche (51).

2. Élément optique réfléchissant selon la revendication 1, lequel est conçu pour différents angles d'incidence du rayonnement EUV sur la surface du système multicouche, **caractérisé en ce que** la proportion des au moins deux substances varie en fonction de l'angle d'incidence.

3. Élément optique réfléchissant selon la revendication 1 ou 2, **caractérisé en ce que** la proportion des au moins deux substances varie de manière continue.

4. Élément optique réfléchissant selon l'une des revendications 1 à 3, **caractérisé en ce que**, dans l'au moins un empilement (53'), le matériau de la couche (55', 54') ayant une partie réelle d'indice de réfraction plus faible ou plus élevée est une combinaison d'exactement deux substances.

5. Élément optique réfléchissant selon l'une des revendications 1 à 4, **caractérisé en ce que**, dans l'au moins un empilement (53', 53"), la couche (55', 54') ayant une partie réelle d'indice de réfraction plus faible ou plus élevée est conçue à partir de couches partielles (551, 552, 541, 542) formées des au moins deux substances dont les épaisseurs de couche partielle respectives sur au moins une partie de surface (61', 61", 61) sont différentes de celles sur la surface restante (61, 61', 61") du système multicouche (51).

6. Élément optique réfléchissant selon l'une des revendications 1 à 4, **caractérisé en ce que**, dans l'au moins un empilement (53', 53"), le matériau de la couche (55') ayant une partie réelle d'indice de réfraction plus faible ou plus élevée présente un rapport de mélange des au moins deux substances qui est sur au moins une partie de surface (61', 61", 61) différent de celui sur la surface restante (61, 61', 61") du système multicouche (51).

7. Élément optique réfléchissant selon l'une des revendications 1 à 6, **caractérisé en ce que**, sur au moins une partie de surface, l'épaisseur totale et/ou le rapport de l'épaisseur de la couche (55, 55') ayant une partie réelle d'indice de réfraction plus faible à l'épaisseur totale d'au moins un empilement (53) est différent de celui de la surface restante du système multicouche (51).

8. Élément optique réfléchissant selon la revendication 1 ou 2, **caractérisé en ce que** le matériau d'au moins une couche (54, 54', 55, 55') varie en termes de densité.

9. Élément optique réfléchissant selon l'une des revendications 1 à 8, **caractérisé en ce qu'**il présente, en tant que matériau ayant une partie réelle d'indice de réfraction plus élevée, du silicium, en tant que matériau ayant une partie réelle d'indice de réfraction plus faible, du molybdène et en tant qu'au moins deux substances, au moins deux éléments du groupe comprenant le molybdène, le ruthénium, le niobium, le scandium, le titane, le carbone, un carbure ou il présente, en tant que matériau ayant une partie réelle d'indice de réfraction plus faible, du ruthénium, ou en tant que matériau ayant une partie réelle d'indice de réfraction plus élevée, du silicium et en tant qu'au moins deux substances, au moins deux éléments du groupe comprenant le silicium, le carbure de bore, le béryllium, le bore, le carbone.

10. Système optique destiné à la lithographie EUV et comprenant un élément optique réfléchissant selon l'une des revendications 1 à 9.

11. Système optique selon la revendication 10, dans lequel le rayonnement ultraviolet extrême ayant une longueur d'onde est incident à l'élément optique réfléchissant avec un angle d'incidence variant sur la surface du système multicouche, **caractérisé en ce que** la proportion des au moins deux substances varie en fonction de l'angle d'incidence.

12. Dispositif de lithographie EUV comprenant un élément optique réfléchissant selon l'une des revendications 1 à 9 ou un système optique selon la revendication 10 ou 11.
